(19) Europäisches Patentamt
European Patent Office
Office européen des brevets

(11) **EP 4 672 589 A1**

(12) **EUROPEAN PATENT APPLICATION**

(43) Date of publication:
**31.12.2025 Bulletin 2026/01**

(21) Application number: **24382698.9**

(22) Date of filing: **28.06.2024**

(51) International Patent Classification (IPC):
**H02N 2/18** (2006.01)   **H10N 30/30** (2023.01)
**H10N 30/01** (2023.01)   **H10N 30/04** (2023.01)

(52) Cooperative Patent Classification (CPC):
**H02N 2/188; H10N 30/01; H10N 30/04;
H10N 30/306**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
• **Energiot Devices, S.L.**
**08193 Cerdanyola del Vallès (ES)**

• **Consejo Superior de Investigaciones Científicas
(CSIC)**
**28006 Madrid (ES)**

(72) Inventors:
• **Murillo Rodríguez, Gonzalo**
**28006 Madrid (ES)**
• **Duque Duque, Marcos**
**28006 Madrid (ES)**

(74) Representative: **Pons IP**
**Glorieta Rubén Darío 4
28010 Madrid (ES)**

(54) **MAGNETOELECTRIC ENERGY GENERATOR AND MANUFACTURING PROCESS THEREOF**

(57)   Disclosed is a magnetoelectric (ME) energy generator comprising a set of connected piezoelectric microelectromechanical system (MEMS) resonators for capturing electromagnetic energy in the microtesla range, each comprising a substrate block (1) having a cantilever portion (10) which carries a first metallic electrode layer (6), a piezoelectric layer (7), and a second metallic electrode layer (5) thereon. An inertial mass (8) is placed under the cantilever portion, and a magnetic mass (9) is placed on top of the cantilever portion, both masses close to the free end of the cantilever portion. A corresponding manufacturing process is also described.

**FIG. 5**

**Description**

## OBJECT OF THE INVENTION

The invention is related to the field of energy generation, more particularly to magnetoelectric energy generation.

The object of the invention is a magnetoelectric (ME) energy generator for capturing residual electromagnetic (EM) energy which allows to obtain energy using multiple piezoelectric microelectromechanical system (MEMS) resonators and increasing the power density by reducing the space needed and increasing the power generated.

Other object of the invention is a manufacturing method for the magnetoelectric (ME) energy generator in a reduced space and increasing the power obtained as the sum of the power of the piezoelectric microelectromechanical system (MEMS) resonators.

## BACKGROUND ART

In the recent decades, Internet of Things (IoT) has experienced an extraordinary growth, emerging as a revolutionary interconnected network spanning from household devices to complex industrial infrastructures.

However, as the IoT has become more deeply integrated into our daily lives and various industrial sectors, the attention has been focused on crucial challenges threatening its sustainable expansion. One of the most prominent obstacles is the energy dependence on batteries in IoT devices, leading to significant limitations in terms of lifespan, maintenance, and associated costs.

This issue in the context of IoT has prompted an active search for innovative solutions, and in this context, energy harvesting (EH) has emerged as a promising field. EH offers the possibility of freeing IoT from its reliance on traditional energy sources, providing a sustainable and autonomous power source.

This approach, leveraging various ambient energy sources, presents a paradigm shift in how we conceive the powering of IoT devices and, therefore, has the potential to catalyze a new era of expansion and efficiency in this interconnected network.

Various environmental energy sources, such as thermal, light, electromagnetic (EM), radiofrequency (RF), mechanical, and chemical energy, can be harnessed for energy harvesting and IoT implementation.

EM energy harvesting is attractive for most IoT applications due to the ubiquitous availability of EM radiations and wireless communications. Depending on the size and scope of the application, near-field or far-field radiations are used. In the near field, magnetic fields (MF) and EM are induced to generate electrical power and wirelessly power devices.

Research in the field of piezoelectric materials has been fundamental for the advancement of various technologies in disciplines ranging from electronics to medicine. These materials exhibit the unique property of generating an electric field in response to mechanical stress and, in the other way around, a deformation is created when applied an electric potential.

This dual functionality, known as the piezoelectric effect, has driven a wide range of innovative applications and led to the design and development of highly efficient electromechanical devices. The convergence of piezoelectric and magnetic materials has generated a promising research area in the EH domain.

In this context, the fundamental concept lies in applying mechanical stresses to piezoelectric materials through interaction with magnetic fields. The ability of these materials to respond to magnetic forces coupled with their inherent ability to convert that response into electrical energy, represents a promising approach to addressing power challenges in autonomous devices and distributed sensor systems.

In ME energy harvesting with piezoelectric materials, most applications rely on the use of MF with magnitudes on the order of militeslas. These MFs, essential for power generation, are commonly found in environments where a significant current flows through conductors, such as in transmission and distribution lines and associated transformer stations.

However, when venturing into more everyday environments, such as homes, offices, or industries, a significant reduction in the intensity of magnetic fields is encountered. In these places, MF typically decreases by approximately an order of magnitude, reaching microteslas levels. This decrease poses a significant challenge when seeking to harness this weaker MF for energy harvesting intended for use in IoT sensor applications.

While applications in environments with more intense currents offer promising opportunities, a more innovative and efficient approach is needed to harness microteslas present in everyday environments. Overcoming these limitations would enable the more widespread implementation of EM energy harvesting technologies in a variety of contexts.

One way to address the use of magnetic fields (MF) in the microtesla level could be using multiple resonators. Nevertheless, the resonant frequency of resonators has a margin of tolerance. This tolerance and the high-quality factor that resonators have, could lead to have resonators with frequencies that are very close, but that are not the same. In this case, the resonators could be resonating in counterphase, and the energies generated by each one may not add up, or even worse, may cancel each other out.

There are techniques for coupling the resonators. For example, application of a bias DC voltage to the piezoelectric material, nevertheless, it makes it necessary to have an external source to modify the frequency. In addition, this voltage would be multiplied depending on the number of resonators connected in parallel.

Other technique for frequency coupling the resonators would be adding an extra mass after the manufacturing process, but it would have to be done for each of the resonators.

In these techniques, an extra subsequent work of measuring the resonance of each of the resonators needs to be performed to know what voltage has to be applied for each of the cases.

## DESCRIPTION OF THE INVENTION

The invention relates to a magnetoelectric (ME) energy generator, which comprises a plurality of piezoelectric microelectromechanical system (MEMS) resonator.

The MEMS resonators comprise a magnetic mass to interact with ambient magnetic fields (MFs), allowing to address energy challenges and promote the sustainable autonomy of IoT devices.

The piezoelectric generator of the invention is designed to capture residual electromagnetic (EM) energy from the environment, specifically in the microteslas range, and convert it into usable energy. In preferred embodiments, the magnetoelectric (ME) energy generator of the invention could be configured to be connected to an Internet of things (IOT) device.

To achieve this purpose, piezoelectric MEMS resonators connected between them are employed, adding to each MEMS resonator a magnetic tip mass for interacting with magnetic fields.

Each MEMS resonator of the invention comprises:

- a substrate block, comprising a cantilever portion;
- a first metallic electrode layer placed on top of the substrate block in the cantilever portion;
- a piezoelectric layer placed on top of the first metallic electrode layer;
- a second metallic electrode layer placed on top of the piezoelectric layer;
- an inertial mass placed below the substrate block on the cantilever portion next to first metallic electrode layer; and
- a magnetic mass placed over the cantilever portion of the substrate block next to first metallic electrode layer.

It has to be noted that the resonance frequency of a set of MEMS resonators, manufactured in parallel, has a margin of tolerance due to the different manufacturing processes to which its substrate is subjected.

This tolerance, together with the high-quality factor that MEMS resonators have, can mean that the MEMS resonators are not suitable for the same application or that they have frequencies that are very close, but not the same. Thus, the MEMS resonators could be resonating in counterphase.

In this way, the energies generated by each one may not add up, or what is even worse, they may cancel each other out. Nevertheless, adding the magnetic mass at the tip of the cantilever portion the masses are magnetically attracted to each other, coupling the frequencies and allowing to add up the energy of each MEMS resonator.

Alternatively, the MEMS resonators could be arranged to repel each other. In any case, the magnetic force from the magnetic mass allows to force resonance motion in a certain phase.

Even more, even if the MEMS resonators are separated and the magnetic masses of the MEMS resonators are not attracted between them, the magnetic moment created by an external field on every magnetic mass also allows to set in phase the MEMS resonators.

Preferably, the substrate block of the magnetoelectric (ME) energy generator of the invention could comprise:

- a first substrate layer made of silicon and with a thickness in the range of 1 $\mu$m to 100 $\mu$m;
- a second substrate layer made of SiO2 and with a thickness in the range of 0,1 $\mu$m to 20 $\mu$m; and
- and a bulk silicon layer with a thickness in the range of 100 $\mu$m to 1mm.

Regarding the piezoelectric layer, it could be made of aluminum nitride (AIN) and could have a thickness in the range of 0,1 $\mu$m to 10 $\mu$m. The first and second metallic electrode layers could be bilayered metallic electrodes made of titanium (Ti), platinum (Pt) or Molybdenum (Mo). More preferably, said first and second metallic electrode layers could have a thickness of 20nm to 200nm.

In some embodiments, the magnetic mass could have dimensions in the milimeter range, more specifically, it could have an area of 3mmx5mm and a thickness of 2mm and the cantilever portion could have an area of 3mmx5mm.

Preferably, each MEMS resonator could further comprise a support, such that the substrate block is placed over the support.

In some embodiments, the support could have an area of 5mmx5mm and a thickness of 0.5mm, being the volume of the MEMS resonator 37.5 mm3, letting 0.5mm over and under the cantilever portion to resonate.

Regarding the magnetic mass, it could be made of Neodymium, Nickel, Ferrite, iron or magneto-strictive materials, such as GaFe or Terfenol-D.

In preferred embodiments, the set of MEMS resonators could be manufactured parallelly and arranged as an array. More preferably, the set of MEMS resonators could be arranged as a stack of arrays. This stack would comprise a wafer placed between each pair of microelectromechanical systems (MEMS) as spacing element.

The invention also relates to a magnetoelectric (ME) energy generation system comprising the magnetoelectric (ME) energy generator defined and a magnetic field generator configured to generate non-harmonic magnetic fields.

Preferably, the magnetic field generator is a magnet configured to roll or rotate interacting with the magnetic masses of the piezoelectric microelectromechanical system (MEMS) resonators of the magnetoelectric (ME) energy generator.

Moreover, by modifying the distance between the magnetoelectric (ME) energy generator and the magnetic field generator and its polarity, the magnetic field generator could produce bi-stable responses in the piezoelectric microelectromechanical system (MEMS) resonators of the magnetoelectric (ME) energy generator. This configuration allows to increase a resonance amplitude, the harvested power and a conversion bandwidth.

Alternatively, the magnetic field generator could produce a Halbach configuration in the magnetoelectric (ME) energy generator. In this configuration, the magnetic field in one side of the array is concentrated and the magnetic field in the other side of the array is cancelled.

The invention also relates to a manufacturing process for the magnetoelectric (ME) energy generator comprising the steps of:

- providing a set of MEMS resonators for capturing residual electromagnetic energy in microtesla range by:

  ◦ providing a substrate block,
  ◦ placing a first metallic electrode layer on top of the substrate block;
  ◦ placing a piezoelectric layer on top of the first metallic electrode layer;
  ◦ placing second metallic electrode layer on top of the piezoelectric layer;
  ◦ performing photolithography and etching techniques to define a cantilever portion on the substrate block, being the first metallic electrode layer in the cantilever portion of the substrate block, and to define an inertial mass in said cantilever portion;
  ◦ placing a magnetic mass on top of the substrate block in the cantilever portion, next to the first metallic electrode and in an opposite side to the inertial mass; and

- arranging the MEMS resonators connected between them.

Preferably, the step of providing a set of MEMS resonators could be performed in vacuum conditions. In this way, it is possible to reduce viscous damping due to air, thus the quality factor of the MEMS resonator is increased and also the harvested energy.

Due to tolerances of the manufacturing process, it will be impossible to obtain the same resonance frequency for all the resonators in the array. For that reason, in preferred embodiments, the step of providing a set of MEMS resonators could further comprise the steps of:

- placing drops of printable materials at the top of the magnetic mass, preferably by using inkjet printing techniques, for increasing a resonance frequency of the MEMS resonator;
- measuring resonance frequency, preferably by using an electronic acquisition system;
- repeating the steps of placing drops of printable materials and measuring resonance frequency until the resonance frequency of all the MEMS resonators is the same.

Preferably, these steps could be automatized controlling digitally the inkjet printing.

The method of the invention allows to obtain an array of magnetically-coupled vacuum-package high-quality MEMS resonators. Also, it makes possible a non-harmonic magnetic actuation by means of a moving magnet, such as a rolling neodymium ball. In that case, when the magnet passes close to the MEMS resonator, said magnet creates a pulse actuation, exciting several frequency components to allow the harvesting of energy. Since the MEMS resonators have high-quality factor, it keeps resonating, harvesting more energy.

Also, this type of MEMS resonators allows to perform up-frequency conversion, wherein an input magnetic field with a frequency being multiple of the resonance frequency is used to excite harmonics of the MEMS resonator.

Also, the step of arranging the MEMS resonators is performed to anchor the MEMS resonators by its nodal points.

Anchoring the MEMS resonators by its nodal points reduce anchor losses, which are losses of energy due to the anchoring of the MEMS resonators in the array. A MEMS resonator has nodal points, which are the points with minimum or zero deformation at a certain resonance mode. If the MEMS resonators are anchored by these points the energy going out from the system, and lost, can be reduced.

Preferably, the steps of placing the first and second metallic electrode layers and the step of placing a piezoelectric layer are performed by RF reactive sputtering.

Also, the step of performing photolithography and etching techniques to define a cantilever portion on the substrate layer could comprise the substeps of:

- performing photolithography steps and deep reactive ion etching (DRIE); and
- performing a wet etching process, preferably, based on hydrofluoric acid (HF).

Regarding the step of placing the magnetic mass, it could comprises the substeps of:

- applying an epoxy layer to one face of the magnetic mass, and
- positioning the magnetic mass on top of the substrate block by using a pick-and-place machine.

Alternatively, the step of placing the magnetic mass could comprise the substeps of:

- depositing a seed layer by evaporation techniques, and
- depositing the magnetic mass on top of the substrate layer by electrodeposition.

## DESCRIPTION OF THE DRAWINGS

Figure 1 shows (a) a representation of a MEMS resonator according to the invention; (b) a representation of the layers in the MEMS resonator; and (c) a representation of an exemplary embodiment of the manufacturing method of the invention.

Figure 2 shows a model of the simulated piezoelectric MEMS resonator to assess the resonance frequency and displacement both (a) without and (b) with mass; also shows a graphical representation of the simulation results of (c) the open-circuit voltage, and (d) the maximum generated power with the optimal load impedance of the simulated structures.

Figure 3 shows a (a) setup for electrical characterization of the MEMS resonator of the invention, used for emulate ambient vibration with a shaker and for emulate magnetic field with Helmholtz coils; a (b) MEMS resonator mounted on a PCB to serve as mechanical support and electrical connection; the MEMS resonator at resonance for an acceleration of 0.1 G (c) without magnetic tip mass; and 0.01 G (d) with magnetic tip mass; also a graph of the (e) results obtained from the characterization comparing the maximum generated power with the optimal load impedance of the device.

Figure 4 shows an (a) example application of the MEMS resonator of the invention with two stoves, by using the magnetic field generated by the current passing through the cable to magnetically stimulate the MEMS resonator; and a graph showing (b) the maximum power obtained for magnetic fields ranging from 2.5 $\mu$T to 5 $\mu$T.

Figure 5 shows a representation of the layers in the MEMS resonator in an alternative embodiment of the invention.

Figure 6 shows a representation of (a) an array of MEMS resonators; (b) a stack of arrays of MEMS resonators and (c) a graph showing the correlation between the acceleration and the power generated.

## PREFERRED EMBODIMENTS OF THE INVENTION

The present invention relates to a magnetoelectric (ME) energy generator for the collection of low-intensity magnetic fields, specifically in the microtesla range. In this way, the magnetoelectric (ME) energy generator of the invention addresses energy challenges in IoT devices

The magnetoelectric (ME) energy generator comprises multiple piezoelectric microelectromechanical system (MEMS) resonators which comprises a magnetic mass (9) designed to interact with ambient magnetic fields (MFs).

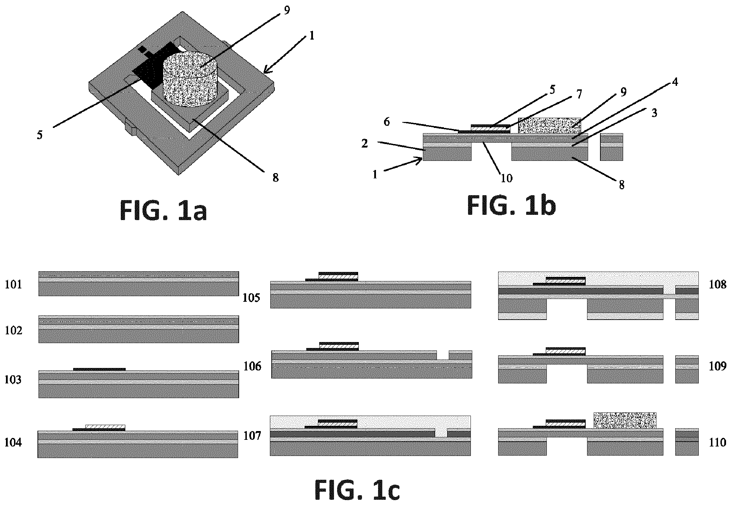

Figures 1a and 1b show a schematic representation of the MEMS resonators of the invention along with a detail of the layers that the MEMS resonator of the invention comprises.

The MEMS resonator comprises a silicon-on-insulator (SOI) substrate (1) with the following thicknesses of the different layers:

- first substrate layer (3): silicon: 15 μm;
- second substrate layer (4): SiO2: 1 μm; and
- bulk substrate layer (2): bulk silicon: 500 μm.

The substrate comprises a cantilever portion (10). Various structural configurations are utilized for piezoelectric energy harvesting devices, with the cantilever, circular diaphragm, and cymbal being the most prevalent. Among these options, the cantilever stands out for its ability to provide the highest energy output as a piezoelectric harvester. Moreover, the cantilever structure achieves a lower resonance frequency for a given size.

The MEMS resonator also comprise a piezoelectric (7) transducer made of a layer of aluminum nitride (AlN) having a 1 μm of thickness. This piezoelectric (7) transducer is sandwiched between two identical bilayered metallic electrodes (5, 6) of Titanium (Ti), Platinum (Pt) or Molybdenum (Mo) with thicknesses of 20 nm and 200 nm, respectively.

The metallic electrodes (5, 6) and the piezoelectric (7) transducer are arranged on a cantilever portion (10) of the substrate. Since, in most applications, the frequency of ambient vibrations is below 1 kHz, the MEMS resonator comprise an inertial mass (8) placed below the substrate (1) on the tip of the cantilever portion (10) to reduce the natural resonance frequency of the MEMS resonator.

Figure 1c describes the manufacturing process of the MEMS resonator of the invention.

The metallic electrode (5, 6) layers, made of Ti, Pt or Mo, are deposited (103) over the substrate (1) through radiofrequency (RF) reactive sputtering. The same technique is employed to deposit the 1 μm-thick piezoelectric transducer layer (7) made of AlN.

The device structure is configured through several photolithography steps and deep reactive ion etching (DRIE) (106, 107, 108). Specifically, a frontside reactive ion etching (RIE) (106) is performed, then, a frontside protective layer is placed (107) and a backside deep reactive ion etching (DRIE) (108) is performed. Upon completion, a wet etching (109) process based on hydrofluoric acid (HF) is employed to remove part of the buried oxide layer, subsequently releasing the cantilever portion (10).

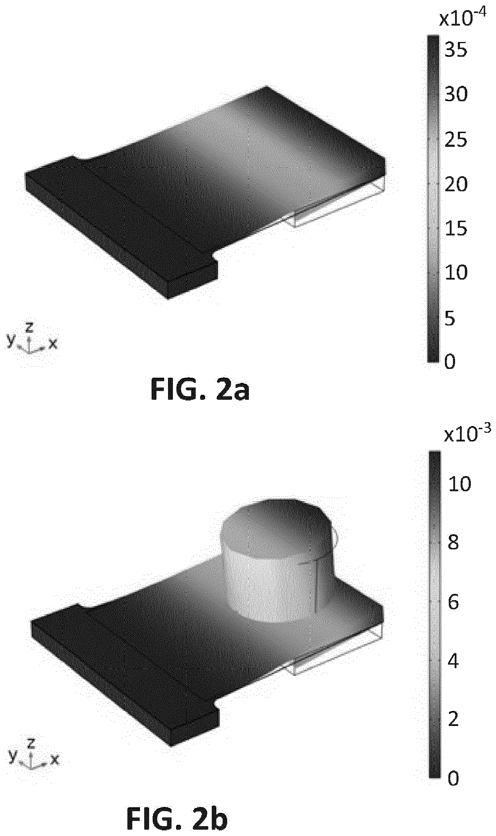

In the preferred embodiment described, shown in Figure 2a, the inertial mass (8) has an area of 3 mm × 5 mm and the cantilever portion (10) has an area of 3 mm × 5 mm.

Then, a neodymium magnetic mass (9) with a diameter of 3 mm and a thickness of 2 mm is placed over the cantilever portion (10), next to the metallic electrodes (5, 6). In this step, firstly, an epoxy layer is applied to one face of the magnetic mass (9), and then it is precisely positioned on top of the substrate (1), in the tip of the cantilever portion (10), using a pick-and-place machine.

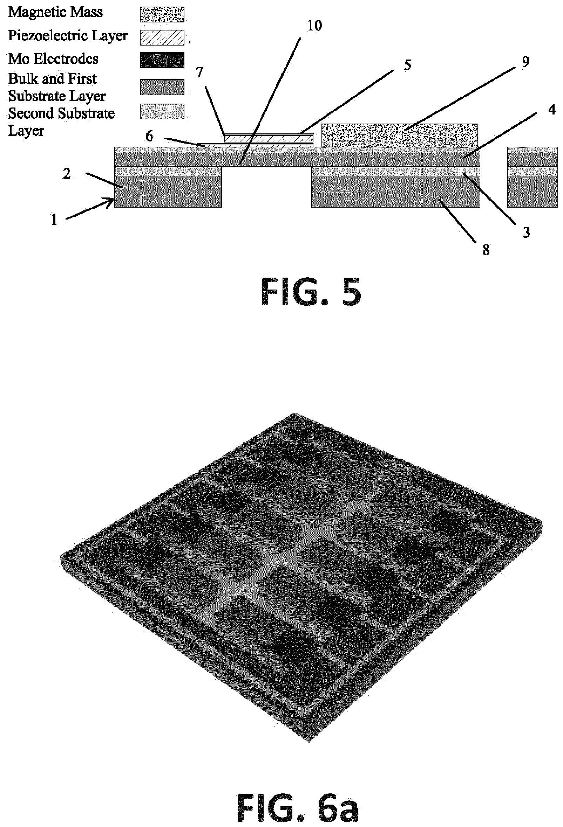

Alternatively, the magnetic mass (9) could be made of Nickel. In this embodiment, a deposition by evaporation of Nickel is performed as a seed layer, then a layer of Nickel having 25 μm of thickness is deposited by using an electrodeposition technique. This embodiment is shown in Figure 5.

The MEMS manufacturing process of the invention allows to provide maximum energy output.

The magnetoelectric (ME) energy generator of the invention comprises a plurality of MEMS resonators. The MEMS resonators are coupled for maximizing the energy density generated.

For a single resonator with 1 mm × 3 mm dimensions, a bracket of approximately 5 mm × 5 mm is needed and occupies a thickness of 0.5 mm, thus having a volume of 12.5 mm³. These resonator devices are cantilever beams that move vertically on the Z axis and need 0.5 mm at the top and bottom to be able to resonate, leading to a total volume of 37.5 mm³ of space needed.

By putting the MEMS resonators in array format, 10 MEMS resonators can be put in a volume of 150 mm3. Taking into account that by putting 10 resonators the power is multiplied by 10 and that the area only increases by a factor of 4, a power density 2.5 times greater is obtained.

In addition, if the MEMS resonators are stacked, using a wafer as a spacer it is possible to share one of the spaces necessary for the MEMS resonator to move. In this way, putting 10 arrays of MEMS resonators in a stack, it would achieve an increase in density 3.75 times greater with respect to a single resonator and 1.5 times greater with respect to a single array.

| N° devices | stack | width | length | deep | Volume | Resonating space | Volume | Volume Relation |
|---|---|---|---|---|---|---|---|---|
| (units) | (mm) | (mm) | (mm) | (mm) | (mm³) | (mm) | (mm³) | |
| 1 | 1 | 5 | 5 | 0,5 | 12,5 | 1 | 37,5 | |
| 10 | 1 | 10 | 10 | 0,5 | 50 | 1 | 150 | 4,00 |

(continued)

| N° devices | stack | width | length | deep | Volume | Resonating space | Volume | Volume Relation |
|---|---|---|---|---|---|---|---|---|
| (units) | (mm) | (mm) | (mm) | (mm) | (mm³) | (mm) | (mm³) | |
| 100 | 10 | 10 | 10 | 0,5 | 500 | 0,5 | 1000 | 26,67 |

Table I.

| N° devices | Power | Power Density (µW/mm³) | Power Density Relation |
|---|---|---|---|
| (units) | (µW) | (µW/mm³) | |
| 1 | 1 | 0,027 | |
| 10 | 10 | 0,067 | 2,5 |
| 100 | 100 | 0,100 | 3,75 |

For demonstrating the potential of the magnetoelectric (ME) energy generator of the invention, a simulation of the electromechanical behavior of a MEMS resonator is performed, examining the impact of the magnetic tip mass (9) on the resonance frequency and optimal impedance of the piezoelectric material. Figure 2a shows the simulation without magnetic mass (9) and Figure 2b shows the simulation with magnetic mass (9).

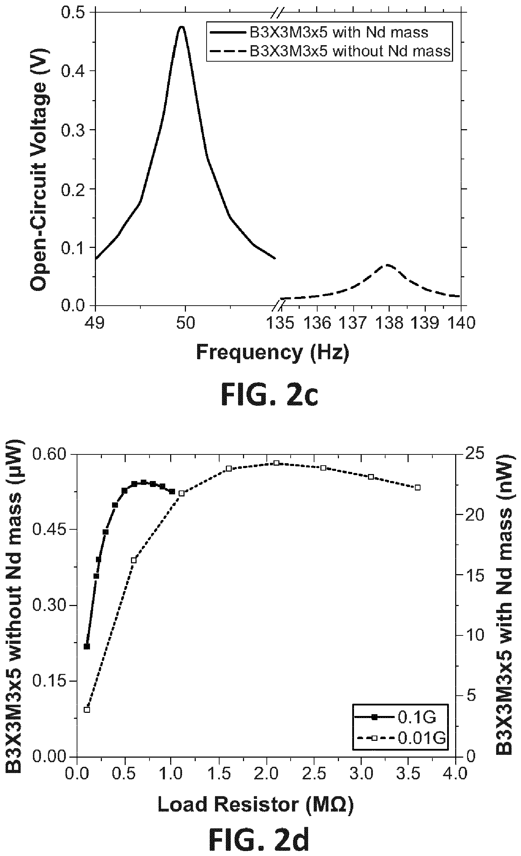

The simulation is performed by using a finite element modelling (FEM). Firstly, a 3D model of the different layers of the MEMS resonator of the invention is performed. Then, a thin mesh with anisotropic density is used to model the mechanical structure. Finally, mechanical and electrostatic equations are solved by the finite element modelling (FEM). The result is the power obtained with and without magnetic mass (9), as shown in Figure 2d.

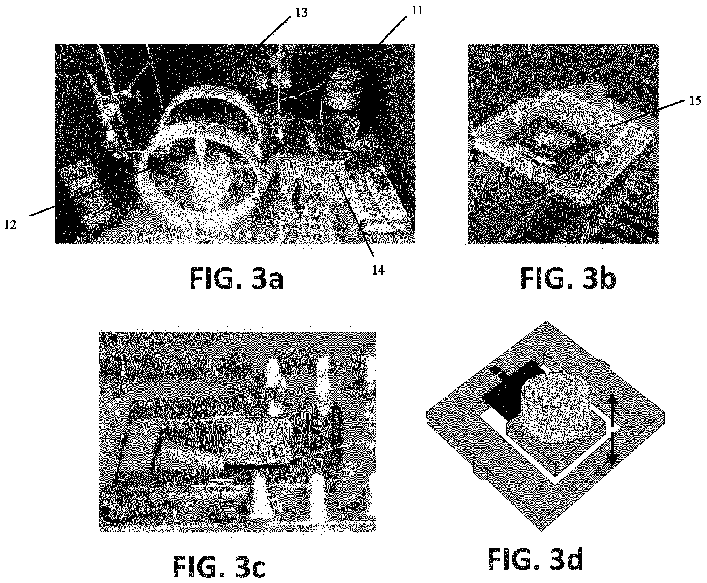

Also, the electrical characterization of the MEMS resonator is performed using an electrodynamic shaker (11) to emulate ambient vibrations with different acceleration magnitudes and a pair of Helmholtz coils to emulate magnetic fields (MFs), as shown in Figure 3a.

A high-impedance acquisition system (14) with an input impedance of 100 MΩ was used to measure the generated voltage, shown in figure 2c. The device under test (DUT) was connected and mounted through a pick-and-place machine onto a specifically designed PCB (15), to provide physical support and electrical connection, as shown in Figure 3b.

The characterization under controlled magnetic fields was conducted using a pair of Helmholtz coils (13) designed to emulate linear alternate-current (AC) magnetic fields (MF) of up to 1 mT. A function generator is used for the adjustment of the frequency and amplitude of the EM field connected to an EM field meter (12), as shown in Figure 3a.

Then, the high-impedance acquisition system (14) is used to measure the generated voltage, the EM field meter (14) is used to verify the magnetic field strength, and a digital microscope is employed to capture the movement of the resonator.

For this embodiment, a high-voltage line conductor is used. This line conductor is made of an aluminum wire wound around a Class A galvanized steel core, with a total diameter of 10.1 mm and capable of supporting currents of up to 242 A.

The results are compared before and after adding the magnetic tip mass (9), Figures 3c and 3d, revealing changes in the resonance frequency, optimal impedance, and generated power.

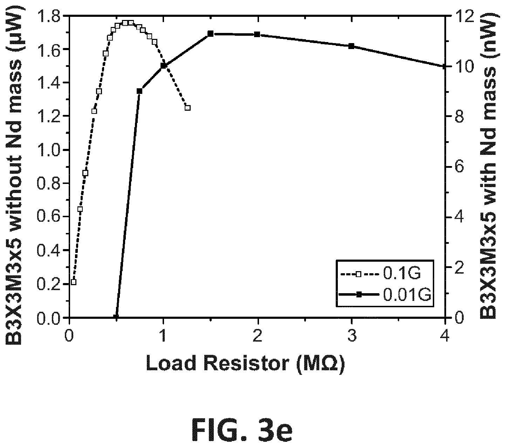

A comparison has been performed between the MEMS resonator with and without a magnetic tip mass (9) to observe how its behavior changes in terms of resonance frequency and optimal impedance of the piezoelectric resonator, as shown in Figure 3e.

This tip mass (9) plays a crucial role in adjusting the resonance frequency to the standard frequency, which is of 50 Hz in European AC electric grid and 60 Hz in USA. Additionally, it will be utilized to interact and harness the ambient magnetic field, inducing a resonance motion in the device.

The resonance frequency ($f_r$) and optimal impedance ($Z_{opt}$) of a piezoelectric MEMS are influenced by various parameters, including the resonator mass (m). These parameters are interrelated and can be described by specific equations. The resonance frequency $f_r$ of a piezoelectric resonator can be described by the following equation, following a simple spring-mass model:

$$f_r = 2\pi \sqrt{\frac{k}{m}}$$

Where k is the effective stiffness constant of the cantilever materials and m is the equivalent mass.

On the other hand, the optimal impedance ($Z_{opt}$) connected to a cantilever for maximum power transfer is related to the resonance frequency ($f_r$) and the internal capacitance ($C_p$) of the piezoelectric material by the equation:

$$Z_{Opt} = \frac{1}{2\pi \, f_r \, C_p}$$

From the previous equations, it can be concluded that as the mass m increases, the resonance frequency $f_r$ tends to decrease. Additionally, the optimal impedance $Z_{opt}$ will also be affected by the increase in mass, as it is directly related to it.

The same MEMS device is simulated with and without a magnetic mass (9) to compare the changes in resonance frequency $f_r$ and optimal resistance $Z_{opt}$, yielding the results shown in Figures 2a, displacement without magnetic mass, 2b, displacement with magnetic mass, 2c, comparison of generated voltage, and 2d, comparison of generated power as a function of the impedance.

From the simulations conducted previously, as shown in Figures 2a and 2b, the resonance frequency shifts from 138 Hz to 50 Hz upon adding a cylindrical neodymium mass (9) with a diameter of 3 mm and a thickness of 2 mm.

As mentioned earlier and as shown Figure 2c, increasing the mass decreases the resonance frequency and, in turn, increases the displacement amplitude. Additionally, as shown in Figure 2d, its optimal impedance increases from 500 KΩ to 2 MΩ.

The maximum generated power, for an acceleration magnitude of 0.2 GΩ at 50 Hz, shows a decrease, since it is inversely proportional to the optimal load impedance. In this case, a greater importance is given to the resonance frequency, to adjust it to the 50 Hz of the ambient magnetic fields.

Two electrical characterizations are performed using two different types of ambient sources. Firstly, by emulating ambient vibrations using an electrodynamic shaker (11), as shown in Figure 3a.

Also, to perform the characterization, a frequency sweep is carried out to identify the resonance frequency of the MEMS resonator. Once the resonance frequency is determined, a load resistance sweep is performed to find the optimal impedance and maximum power that the piezoelectric resonator can generate.

To compare data from simulations with results measured in laboratory, the electrical characterization of the resonator is initially conducted before incorporating the magnetic mass (9). Then, the neodymium magnetic mass (9) is attached, as shown in Figure 3b, and the measurements are repeated. Figure 3c and Figure 3d show the device resonating at its resonance frequency before and after adding the magnetic tip mass (9). These frequencies are 134 Hz and 50 Hz, respectively.

As observed in the graph of Figure 3e and confirmed by the results of simulations, when the resonator does not have the neodymium mass (9), its optimal impedance is much lower, 500 kΩ, and its maximum generated power is 1.73 μW compared to the later obtained 2 MΩ, with a power of 11.5 nW. Therefore, the final power generated for the same displacement amplitude is lower.

For performing characterization under controlled magnetic fields, the MEMS resonator is mounted between the two coils (13), using a specifically designed PCB (15) that provided physical support and electrical connection, as shown in Figure 3b.

A load resistance sweep at the resonance frequency of the device was carried out to measure the maximum power generated in magnetic fields (MFs) ranging from 2.5 μT to 5 μT. With 5 μT, a maximum voltage of 1.51 V was obtained, corresponding to a maximum power of 0.55 μW with an optimal load impedance of 2 MΩ. Due to the compact size of the MEMS resonator, the possibility of placing several of these devices in parallel as an array would allow multiplying the power by a factor depending on the number of devices used.

Additionally, by using a charge pump, which is an electric circuit capable to multiply the output voltage of a source, normally based on capacitor switching, it would be feasible to increase the maximum generated voltage if the final application requires it.

Using the magnetoelectric (ME) energy generator of the invention low intensity residual magnetic fields (MFs) are exploitable. Beneath high-voltage power lines, on the walls of transformer buildings, and in the vicinity of transformer substations, values of up to 20-80 μT can be reached. Underground cables of 400 kV can produce a magnetic field intensity of over 30 μT at ground level, decreasing to 10 μT at 2 meters above the ground. In public transportation such as metro stations, trains, and high-distance trains, values between 5.4 μT and 7.9 μT are obtained. Additionally, most household appliances generate magnetic fields (MFs) ranging from 2.5 μT to 1500 μT at a distance of 3 cm.

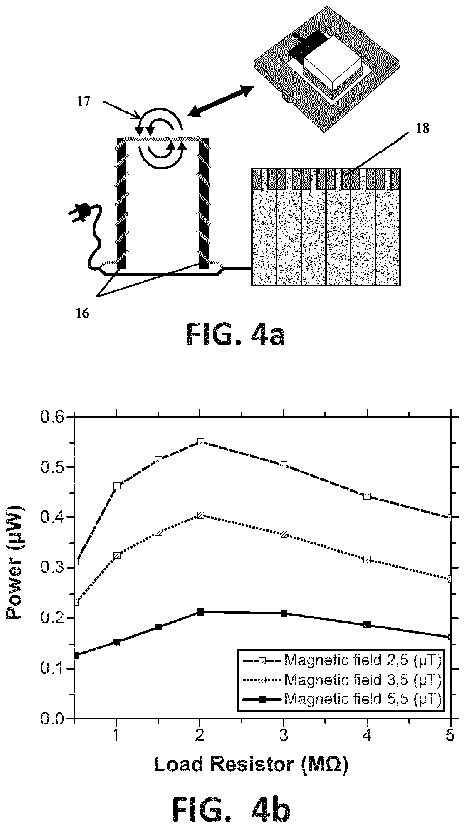

To validate the proper operation of the energy generator of the invention in the cases mentioned above, a setup for magnetic field (MF) generation has been used, as shown in Figure 4a. This setup essentially consists of a conductor used on high-voltage towers to carry high intensity currents and is suspended between two poles (16).

Two oil-filled radiator heaters (18) are connected as electric load to the circuit. By turning on these radiators, the conductor manages to carry 15 A, generating a magnetic field (MF) (17) of 5 $\mu$T at a distance of 60 cm.

As shown in Figure 4b, a maximum output voltage of 1.51 V is measured and a maximum power of 0.55 $\mu$W. It is important to note that, thanks to the small dimensions of the MEMS resonator, less than 60 mm$^3$, a power density of 9.19 $\mu$W/cm$^3$ is achieved. This value is considerably higher than similar applications using larger devices, reaching a power density between 0.53 $\mu$W/cm$^3$ and 1.86 $\mu$W/cm$^3$ for slightly higher magnetic fields (MFs) of around 7 $\mu$T.

Therefore, the energy generator of the invention is functional in proximity to a wide variety of household appliances used daily and would be able to capture ambient magnetic fields (MFs) to power, for example, low-power IoT sensors for monitoring environmental conditions.

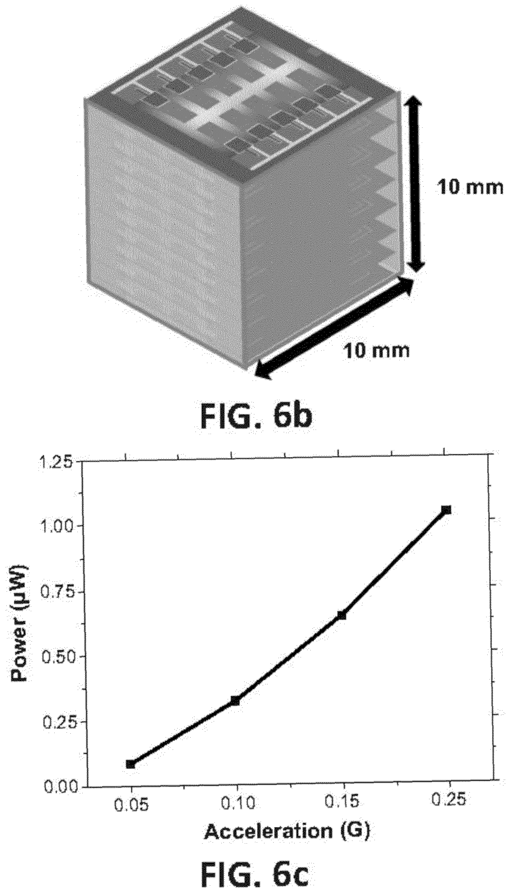

Figure 6a shows an implementation of the magnetoelectric (ME) energy generator as an array of MEMS resonators, and Figure 6b shows an implementation as a stack of arrays of MEMS resonators. Figure 6c shows the power generated by a MEMS resonator as a function of the acceleration to which it is subjected. At 0.2G, the power generated is 1$\mu$W.

**Claims**

1. A magnetoelectric (ME) energy generator comprising a set of piezoelectric microelectromechanical system (MEMS) resonators for capturing electromagnetic energy (EM) in microtesla range connected between them and comprising each piezoelectric microelectromechanical system (MEMS) resonator:

    - a substrate block (1), comprising a cantilever portion (10);
    - a first metallic electrode (6) layer placed on top of the substrate block (1) in the cantilever portion (10);
    - a piezoelectric layer (7) placed on top of the first metallic electrode (6) layer;
    - a second metallic electrode (5) layer placed on top of the piezoelectric layer (7);
    - an inertial mass (8) placed below the substrate block (1) on the cantilever portion (10) next to first metallic electrode (6) layer; and
    - a magnetic mass (9) placed over the cantilever portion (10) of the substrate block (1) next to first metallic electrode (6) layer.

2. The magnetoelectric (ME) energy generator to claim 1, wherein the substrate block (1) comprises:

    - a first substrate layer (4) made of silicon and with a thickness in the range of 1 $\mu$m to 100 $\mu$m;
    - a second substrate layer (3) made of SiO2 and with a thickness in the range of 0,1 $\mu$m to 20 $\mu$m; and
    - and a bulk silicon layer (2) with a thickness in the range of 100 $\mu$m to 1mm.

3. The magnetoelectric (ME) energy generator according to claim 1, wherein the piezoelectric layer (7) is made of aluminum nitride (AIN) and has a thickness in the range of 0,1 $\mu$m to 10 $\mu$m.

4. The magnetoelectric (ME) energy generator according to claim 1, wherein the magnetic mass (9) is made of Neodymium, Nickel, Ferrite, iron or magneto-strictive materials, and has an area and a thickness in the millimeter range.

5. **The** magnetoelectric (ME) energy generator according to claim 1, wherein the set of piezoelectric microelectromechanical system (MEMS) resonators are manufactured parallelly and arranged as an array or as a stack of arrays comprising serial and parallel electrical connections.

6. A magnetoelectric (ME) energy generation system comprising a magnetoelectric (ME) energy generator according to any of claims 1 to 5 and a magnetic field generator configured to generate non-harmonic magnetic fields.

7. The magnetoelectric (ME) energy generation system according to claim 6, wherein the magnetic field generator is a magnet configured to roll or rotate interacting with the magnetic masses (9) of the piezoelectric microelectromechanical system (MEMS) resonators of the magnetoelectric (ME) energy generator.

8. The magnetoelectric (ME) energy generation system according to claim 6, wherein the magnetic field generator is configured to produce bi-stable responses in the piezoelectric microelectromechanical system (MEMS) resonators of the magnetoelectric (ME) energy generator or to produce a Halbach configuration in the magnetoelectric (ME) energy generator.

9. A manufacturing process for a magnetoelectric (ME) energy generator comprising the steps of:

- providing a set of piezoelectric microelectromechanical system (MEMS) resonators for capturing residual electromagnetic energy in microtesla range by:

  ○ providing (101, 102) a substrate block (1),
  ○ placing (103) a first metallic electrode (6) layer on top of the substrate block (1);
  ○ placing (104) a piezoelectric layer (7) on top of the first metallic electrode (6) layer;
  ○ placing (105) second metallic electrode (5) layer on top of the piezoelectric layer (7);
  ○ performing photolithography and etching techniques (106, 107, 108, 109) to define a cantilever portion (10) on the substrate block (1), being the first metallic electrode (6) layer in the cantilever portion (10) of the substrate block (1), and to define an inertial mass (8) in said cantilever portion (10);
  ○ placing (110) a magnetic mass (9) on top of the substrate block (1) in the cantilever portion (10), next to the first metallic electrode (6) and in an opposite side to the inertial mass (8); and

- arranging the piezoelectric microelectromechanical system (MEMS) resonators connected between them.

10. The manufacturing process according to claim 9, wherein the step of providing a set of piezoelectric microelectromechanical system (MEMS) resonators is performed in vacuum conditions.

11. The manufacturing process according to claim 9, wherein the step of providing a set of piezoelectric microelectromechanical system (MEMS) resonators further comprises the steps of:

- placing drops of printable materials at the top of the magnetic mass;
- measuring resonance frequency;
- repeating the steps of placing drops of printable materials and measuring resonance frequency until the resonance frequency of all the piezoelectric microelectromechanical system (MEMS) resonators is the same.

12. The manufacturing process according to claim 9, wherein the step of arranging the piezoelectric microelectromechanical system (MEMS) resonators is performed to anchor the piezoelectric microelectromechanical system (MEMS) resonators by its nodal points.

13. The manufacturing process according to claim 9, wherein the steps of placing (103) the first and second metallic electrode (5, 6) layers and the step of placing (104) a piezoelectric layer (7) are performed by RF reactive sputtering.

14. The manufacturing process according to claim 9, wherein the step of performing (106, 107, 108, 109) photolithography and etching techniques to define a cantilever portion (10) on the substrate block (1) comprises the substeps of:

- performing (106, 107, 108) photolithography steps and deep reactive ion etching (DRIE); and
- performing (109) a wet etching process.

15. The manufacturing process according to claim 9, wherein the step of placing (110) the magnetic mass (9) comprises the substeps of:

- applying an epoxy layer to one face of the magnetic mass (9), and
- positioning the magnetic mass (9) on top of the substrate block (1) by using a pick-and-place machine; or
- depositing a seed layer by evaporation techniques, and
- depositing the magnetic mass (9) on top of the substrate block (1) by electrodeposition.

**FIG. 1a**

**FIG. 1b**

**FIG. 1c**

FIG. 2a

FIG. 2b

FIG. 2c

FIG. 2d

FIG. 3a

FIG. 3b

FIG. 3c

FIG. 3d

FIG. 3e

**FIG. 4a**

**FIG. 4b**

Magnetic Mass

Piezoelectric Layer

Mo Electrodes

Bulk and First
Substrate Layer

Second Substrate
Layer

**FIG. 5**

**FIG. 6a**

**10 mm**

**10 mm**

## FIG. 6b

## FIG. 6c

Europäisches
Patentamt

European
Patent Office

Office européen
des brevets

# EUROPEAN SEARCH REPORT

**Application Number**

EP 24 38 2698

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | CN 105 720 861 A (NANCHANG INSTITUTE OF TECHNOLOGY) 29 June 2016 (2016-06-29) | 1-7,9, 10,12-15 | INV. H02N2/18 |
| A | * paragraphs [0030] - [0050]; figures 1, 2 * | 8,11 | H10N30/30 H10N30/01 H10N30/04 |
| | ----- | | |
| Y | SHEN D ET AL: "The design, fabrication and evaluation of a MEMS PZT cantilever with an integrated Si proof mass for vibration energy harvesting", JOURNAL OF MICROMECHANICS AND MICROENGINEERING, vol. 18, 055017, 4 April 2008 (2008-04-04) , XP020136843, DOI: 10.1088/0960-1317/18/5/055017 * sections 2, 3; figures 1, 2 * | 1-7,9, 10,12-15 | |
| | ----- | | |
| A | CHALLA V R ET AL: "Towards an autonomous self-tuning vibration energy harvesting device for wireless sensor network applications", SMART MATERIALS AND STRUCTURES, vol. 20, 025004, 6 January 2011 (2011-01-06), XP020204318, DOI: 10.1088/0964-1726/20/2/025004 * sections 2.1, 2.4; figures 1, 3 * | 1-15 | |
| | | | **TECHNICAL FIELDS SEARCHED (IPC)** |
| | | | H02N H10N |
| | ----- | | |
| A | US 2013/154439 A1 (LEE SANG KYUN [KR] ET AL) 20 June 2013 (2013-06-20) * figures 1, 2 * | 1-15 | |
| | ----- | | |
| | -/-- | | |

The present search report has been drawn up for all claims

| Place of search | Date of completion of the search | Examiner |
|---|---|---|
| Munich | 26 November 2024 | Köpf, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

....................................................................................
& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

**Application Number**

EP 24 38 2698

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | YU H ET AL: "A hybrid micro vibration energy harvester with power management circuit", MICROELECTRONIC ENGINEERING, vol. 131, 16 October 2014 (2014-10-16), pages 36-42, XP029018043, DOI: 10.1016/J.MEE.2014.10.008 * section 3.1; figure 2 * | 1-15 | |
| A | CN 102 185 523 A (NORTH CHINA ELECTRIC POWER UNIVERSITY) 14 September 2011 (2011-09-14) * paragraphs [0034] - [0037]; figure 1 * | 1-15 | |

TECHNICAL FIELDS
SEARCHED     (IPC)

The present search report has been drawn up for all claims

| Place of search | Date of completion of the search | Examiner |
|---|---|---|
| Munich | 26 November 2024 | Köpf, Christian |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 .............................................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 38 2698

This annex lists the patent family members relating to the patent documents cited in the above-mentioned European search report.
The members are as contained in the European Patent Office EDP file on
The European Patent Office is in no way liable for these particulars which are merely given for the purpose of information.

26-11-2024

| Patent document cited in search report | | Publication date | Patent family member(s) | | Publication date |
|---|---|---|---|---|---|
| CN 105720861 | A | 29-06-2016 | NONE | | |
| US 2013154439 | A1 | 20-06-2013 | KR | 20130069132 A | 26-06-2013 |
| | | | US | 2013154439 A1 | 20-06-2013 |
| CN 102185523 | A | 14-09-2011 | NONE | | |

EPO FORM P0459